# EUROPEAN PATENT SPECIFICATION

(11) **EP 1 821 347 B1**
(45) Date of publication and mention of the grant of the patent: **03.01.2018**
(21) Application number: 07250583.7
(22) Date of filing: 13.02.2007
(51) Int. Cl.: H01L 33/42

(54) **LIGHT EMITTING DEVICE HAVING VERTICAL STRUCTURE AND METHOD FOR MANUFACTURING THE SAME**
LICHTEMITTIERENDE VORRICHTUNG MIT VERTIKALER STRUKTUR UND VERFAHREN ZU IHRER HERSTELLUNG
DISPOSITIF LUMINESCENT DE STRUCTURE VERTICALE ET SON PROCÉDÉ DE FABRICATION

(30) Priority: 16.02.2006 KR 20060015037; 16.02.2006 KR 20060015038
(43) Date of publication of application: 22.08.2007
(73) Proprietor: LG Electronics Inc., Youngdungpo-Gu Seoul (KR); LG Innotek Co., Ltd., Seoul, 04637 (KR)
(72) Inventor: Jang, Jun Ho, Anyang-si Gyeonggi-do (KR); Ha, Jun Seok, Seocho-gu Seoul (KR)
(74) Representative: Zardi, Marco

(56) References cited:
- EP-A2- 1 727 216
- DE-A1- 19 648 309
- US-A- 5 990 500
- US-A1- 2001 042 860
- US-A1- 2004 061 101
- US-A1- 2005 205 875
- US-B1- 6 479 836
- US-B1- 6 693 352
- MENSZ P M ET AL: "INXGA1-XN/ALYGA1-YN VIOLET LIGHT EMITTING DIODES WITH REFLECTIVE P-CONTACTS FOR HIGH SINGLE SIDED LIGHT EXTRACTION" ELECTRONICS LETTERS, IEE STEVENAGE, GB LNKD- DOI:10.1049/EL:19971379, vol. 33, no. 24, 20 November 1997 (1997-11-20), pages 2066-2068, XP000734311 ISSN: 0013-5194

## Description

The present invention relates to a light emitting device having a vertical structure. It more particularly relates to a light emitting device having a vertical structure which is capable of achieving an enhancement in light escape efficiency, and a method for manufacturing the same.

Light emitting diodes (LEDs) are well known as a semiconductor light emitting device which converts current to light, to emit light. Since a red LED using GaAsP compound semiconductor became commercially available in 1962, it has been used, together with a GaP:N-based green LED, as a light source in electronic apparatuses, for image display.

The wavelength of light emitted from such an LED depends on the semiconductor material used to fabricate the LED. This is because the wavelength of the emitted light depends on the band gap of the semiconductor material representing energy difference between valence-band electrons and conduction-band electrons.

Gallium nitride (GaN) compound semiconductor has been highlighted. One of the reasons why GaN compound semiconductor has been highlighted is that it is possible to fabricate a semiconductor layer capable of emitting green, blue, or white light, using GaN in combination with other elements, for example, indium (In), aluminum (Al), etc.

Thus, it is possible to adjust the wavelength of light to be emitted, using GaN in combination with other appropriate elements. Accordingly, where GaN is used, it is possible to appropriately determine the materials of a desired LED in accordance with the characteristics of the apparatus to which the LED is applied. For example, it is possible to fabricate a blue LED useful for optical recording or a white LED to replace a glow lamp.

On the other hand, initially-developed green LEDs were fabricated using GaP. Since GaP is an indirect transition material causing a degradation in efficiency, the green LEDs fabricated using this material cannot practically produce light of pure green. By virtue of the recent success of growth of an InGaN thin film, however, it has been possible to fabricate a high-luminescent green LED.

By virtue of the above-mentioned advantages and other advantages of GaN-based LEDs, the GaN-based LED market has rapidly grown. Also, techniques associated with GaN-based electro-optic devices have rapidly developed since the GaN-based LEDs became commercially available in 1994.

GaN-based LEDs have been developed to exhibit light emission efficiency superior over that of glow lamps. Currently, the efficiency of GaN-based LEDs is substantially equal to that of fluorescent lamps. Thus, it is expected that the GaN-based LED market will grow significantly.

Despite the rapid advancement in technologies of GaN-based semiconductor devices, the fabrication of GaN-based devices suffers from a great disadvantage of high-production costs. This disadvantage is closely related to difficulties associated with growing of a GaN thin film (epitaxial layer) and subsequent cutting of finished GaN-based devices.

Such a GaN-based device is generally fabricated on a sapphire (Al₂O₃) substrate. This is because a sapphire wafer is commercially available in a size suited for the mass production of GaN-based devices, supports GaN epitaxial growth with a relatively high quality, and exhibits a high processability in a wide range of temperatures.

Further, sapphire is chemically and thermally stable, and has a high-melting point enabling implementation of a high-temperature manufacturing process. Also, sapphire has a high bonding energy (122.4 Kcal/mole) and a high dielectric constant. In terms of a chemical structure, the sapphire is a crystalline aluminum oxide (Al₂O₃).

Meanwhile, since sapphire is an insulating material, available LED devices manufactured using a sapphire substrate (or other insulating substrates) are practically limited to a lateral or vertical structure.

In the lateral structure, all metal contacts for use in injection of electric current into LEDs are positioned on the top surface of the device structure (or on the same substrate surface). On the other hand, in the vertical structure, one metal contact is positioned on the top surface, and the other contact is positioned on the bottom surface of the device structure after removal of the sapphire (insulating) substrate.

In addition, a flip chip bonding method has also been widely employed. In accordance with the flip chip bonding method, an LED chip, which has been separately prepared, is attached to a sub-mount of, for example, a silicon wafer or ceramic substrate having an excellent thermal conductivity, under the condition in which the LED chip is inverted.

However, the lateral structure or the flip chip method suffers from problems associated with poor heat dissipation efficiency because the sapphire substrate has a thermal conductivity of about 27 W/mK, thus leading to a very high thermal resistance. Furthermore, the flip chip method has also disadvantages of requiring large numbers of photolithography process steps, thus resulting in complicated manufacturing processes.

To this end, LED devices having a vertical structure have been highlighted in that the vertical structure involves removal of the sapphire substrate.

In the fabrication of such a vertical LED structure, a laser lift off (LLO) method is used to remove the sapphire substrate, and thus to solve the problems caused by the sapphire substrate.

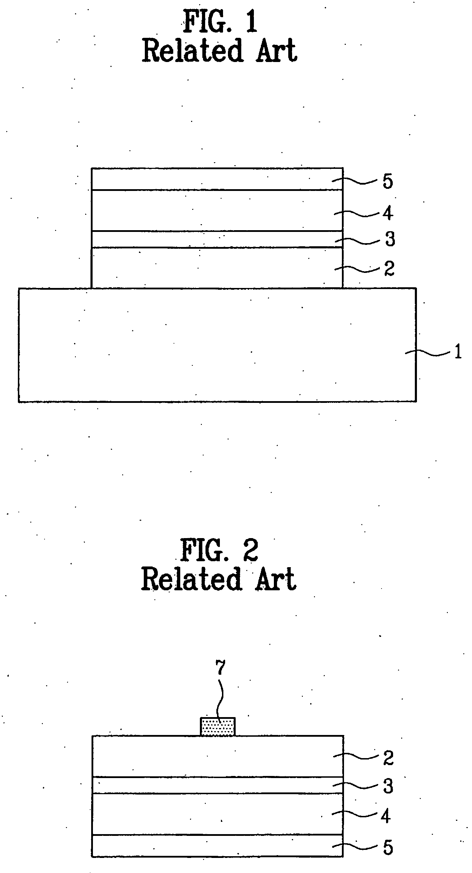

That is, as shown in FIG. 1, over a sapphire substrate 1, a GaN thin film including an n type GaN layer 2, an active layer 3, and a p type GaN layer 4 is formed. A p type electrode 5 is formed over the GaN thin film.

An LLO method is applied to the chip as fabricated in the above-mentioned manner, to completely remove the sapphire substrate 1.

In the LLO method, stress is applied to the GaN thin film upon incidence of a laser beam. In order to separate the sapphire substrate 1 and GaN thin film from each other, it is necessary to use a laser beam having a high energy density. The laser beam decomposes GaN into a metal element, namely, Ga, and nitrogen gas (N₂).

After removal of the substrate 1 as mentioned above, an n type electrode 7 is formed on the exposed n type GaN layer 2, as shown in FIG. 2, to fabricate a chip structure.

In such a vertical LED structure, the n type GaN layer 2 is arranged at the uppermost portion of the chip structure, as shown in the drawing. For this reason, the area of a contact region of the n type GaN layer 2 considerably affects the total light emission efficiency.

Although it is advantageous, in terms of light escape, to reduce the area of the contact region, there may be a problem such as an increase in operating voltage because the reduced contact region causes an increase in the total resistance of the device or insufficient current spreading.

Since the GaN material has a refractive index of 2.35, the angle, through which light from the LED is externally emitted without being fully reflected within the LED, is limited to 25° from a vertical line in the case in which the GaN material is directly in contact with air having a refractive index of 1. US 2001/0042860 A1 teaches a GaN-semiconductor based light emitting device having a transparent contact structure comprising a metal layer and a transparent conducting oxide layer and a vertical structure light emitting device. US 6 693 352 B1 teaches a group III-V semiconductor based light emitting device having transparent contact structures comprising a metal layer and a transparent conducting oxide layer.

The present invention seeks to provide an improved light emitting device and a method for manufacturing the same.

Embodiments of the present invention can provide a light emitting device having a vertical structure which is capable of achieving enhancements in light emission efficiency and light escape efficiency, using a transparent conductive oxide (TCO) laminated over a GaN semiconductor layer, and a getter metal forming ohmic contact between the GaN semiconductor layer and the TCO, and a method for manufacturing the same.

Additional advantages and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the drawings.

One aspect of the invention provides a light emitting device according to claim 1. Other aspects of the invention are defined in the sub-claims.

It is to be understood that both the foregoing general description and the following detailed description of the present invention are exemplary and explanatory and are intended to provide further explanation of the invention as claimed.

Embodiments of the invention will now be described by way of non-limiting example only, with reference to the drawings, in which:
FIG. 1 is sectional view illustrating an example of a conventional process for manufacturing a light emitting device having a vertical structure;
FIG. 2 is sectional view illustrating an example of a conventional light emitting device having a vertical structure;
FIGs. 3 to 11 are sectional view illustrating an arrangement useful for understanding the invention, in which :

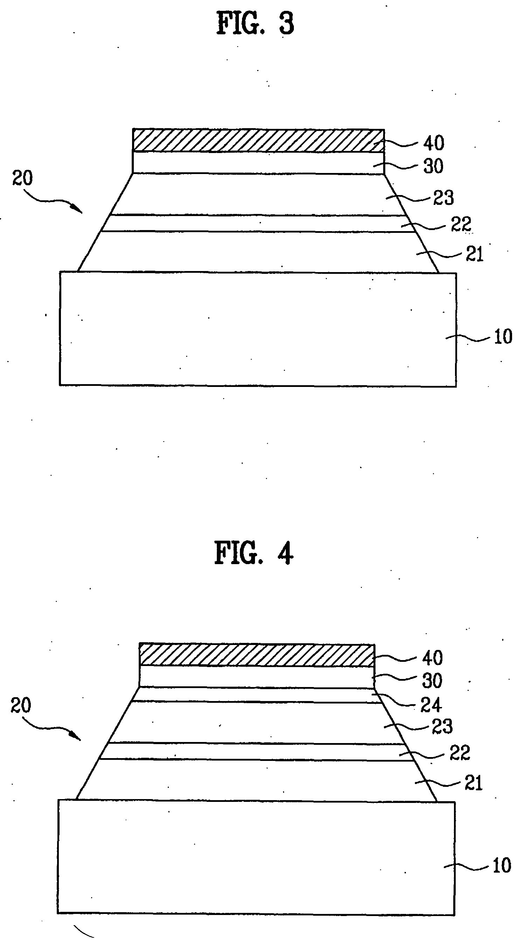

   FIG. 3 is a sectional view illustrating an example of a manufacturing process useful for understanding the invention;
   FIG. 4 is a sectional view illustrating another example of the manufacturing process useful for understanding the invention;

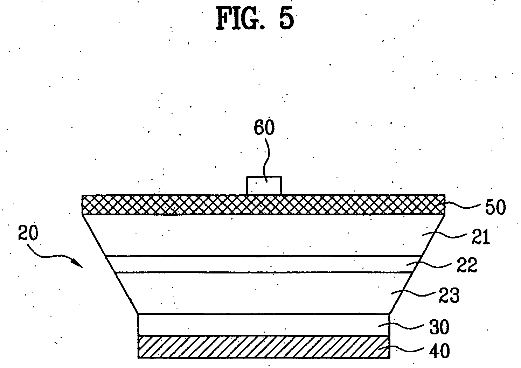

   FIG. 5 is a sectional view illustrating an example of a light emitting device having a vertical structure useful for understanding the invention;

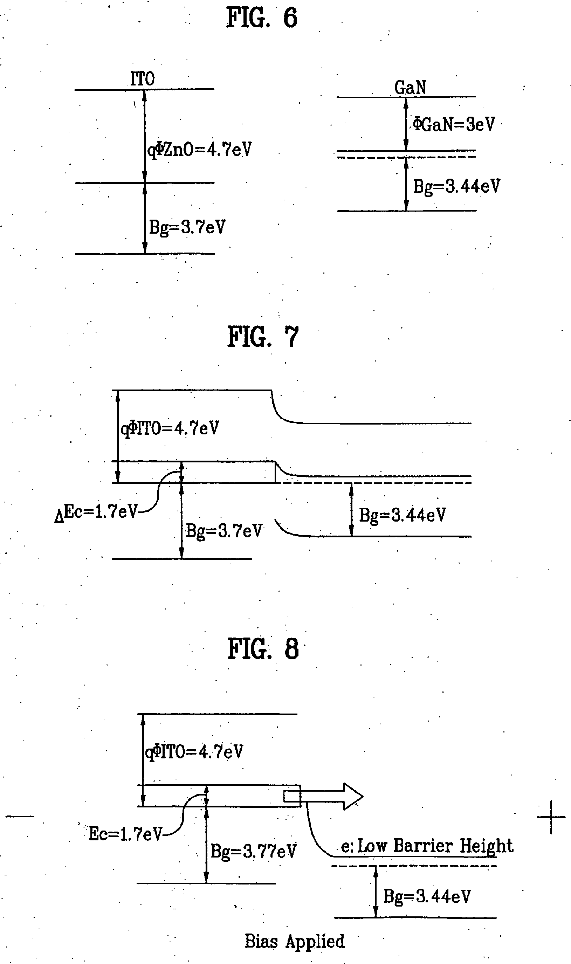

   FIG. 6 is a schematic diagram illustrating band structures of ITO and n type GaN;
   FIG. 7 is a schematic diagram illustrating a band structure formed in a bonded state of ITO and n type GaN;
   FIG. 8 is a schematic diagram illustrating a band structure formed when an electric field is applied to a bonded structure of ITO and n type GaN;

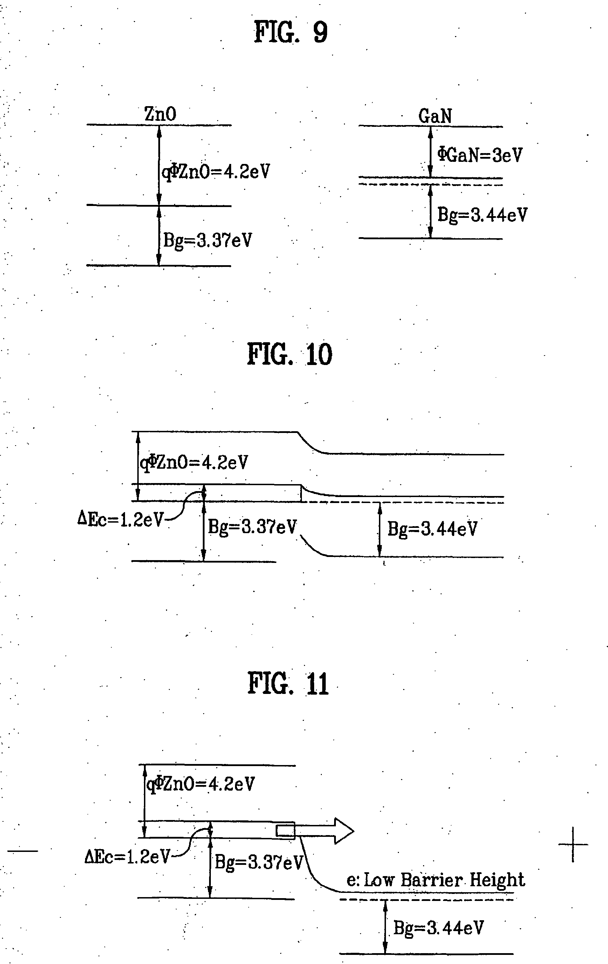

   FIG. 9 is a schematic diagram illustrating band structures of ZnO and n type GaN;
   FIG. 10 is a schematic diagram illustrating a band structure formed in a bonded state of ZnO and n type GaN;
   FIG. 11 is a schematic diagram illustrating a band structure formed when an electric field is applied to a bonded structure of ZnO and n type GaN; and

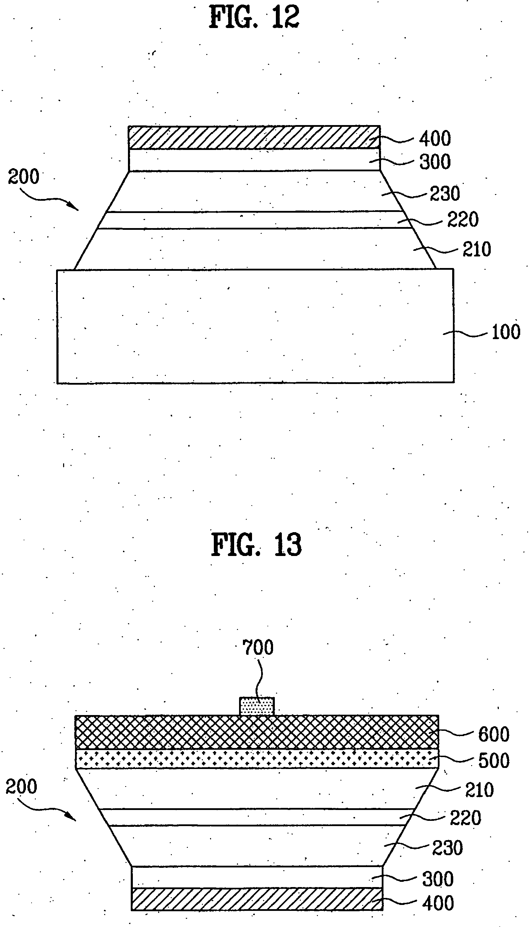

FIGs. 12 to 15 are sectional views illustrating an embodiment of the invention, in which:
   FIG. 12 is a sectional view illustrating an example of a manufacturing process according to the invention;
   FIG. 13 is a sectional view illustrating an example of a light emitting device having a vertical structure manufactured in accordance with the invention;

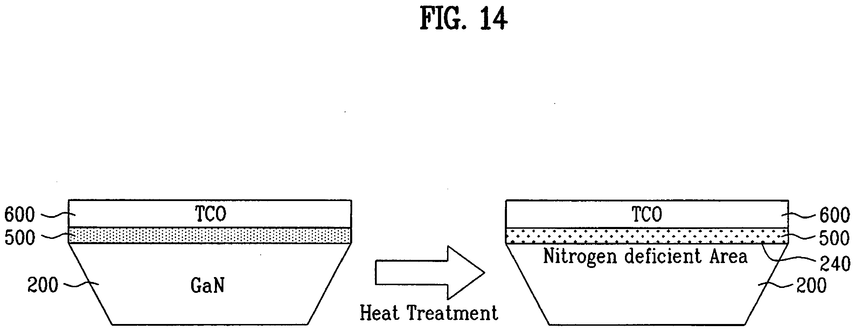

   FIG. 14 is a schematic view illustrating a heat treatment process; and

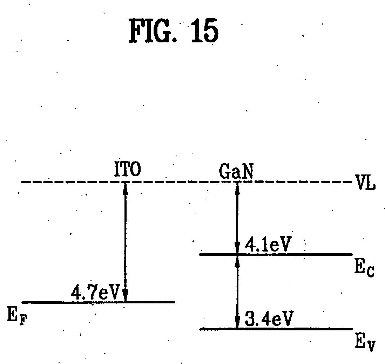

   FIG. 15 is a schematic diagram illustrating band structures of ITO and GaN.

The present invention may be embodied in many alternate forms and should not be construed as limited to the embodiments set forth herein. Accordingly, while the invention is susceptible to various modifications and alternative forms, specific embodiments thereof are shown by way of example in the drawings and will herein be described in detail. It should be understood, however, that there is no intent to limit the invention to the particular forms disclosed, but on the contrary, the invention is to cover all modifications, equivalents, and alternatives falling within the scope of the invention as defined by the claims.

Like numbers refer to like elements throughout the description of the figures. In the drawings, the thickness of layers and regions are exaggerated for clarity.

It will be understood that when an element such as a layer, region or substrate is referred to as being "on" another element, it can be directly on the other element or intervening elements may also be present. It will also be understood that if part of an element, such as a surface, is referred to as "inner," it is further from the outside of the device than other parts of the element.

In addition, relative terms, such as "beneath" and "overlies", may be used herein to describe one layer's or region's relationship to another layer or region as illustrated in the figures.

It will be understood that these terms are intended to encompass different orientations of the device in addition to the orientation depicted in the figures. Finally, the term "directly" means that there are no intervening elements. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms.

These terms are only used to distinguish one region, layer or section from another region, layer or section. Thus, a first region, layer or section discussed below could be termed a second region, layer or section, and similarly, a second region, layer or section may be termed a first region, layer or section without departing from the teachings of the present invention.

As shown in FIG. 3, in order to manufacture a light emitting device, a GaN semiconductor layer 20 having a multilayer structure and a first electrode 30 are formed over a sapphire substrate 10.

The semiconductor layer 20 is grown, using, for example, a general semiconductor growing method. For the semiconductor growing method, various methods, for example, PVD such as sputtering, MOCVD using organic metal pre-cursor, and ion implanting, may be selectively used in accordance with the convenience of the process.

The semiconductor layer 20 includes an n type semiconductor layer 21, an active layer 22, and a p type semiconductor layer 23. As shown in FIG. 3, the semiconductor layer 20 has a structure having an area which gradually reduces with distance from the substrate 10.

If necessary, a current diffusion layer 24 may be formed over the p type semiconductor layer 23, as shown in FIG. 4. For the current diffusion layer 24, an InₓGa₁₋ₓN layer or an InₓGa₁₋ₓN/GaN superlattice layer may be used.

The current diffusion layer 24 can function to enhance mobility of carriers, and thus to cause current to flow smoothly. In this regard, such a current diffusion layer is also called a current transport enhanced layer (CTEL).

The first electrode 30 is an ohmic electrode. Such an ohmic electrode is, in this embodiment, formed using a transparent electrode structure. The first electrode 30 is a p type electrode in this embodiment because it is formed over the p type semiconductor layer 23.

Where a transparent electrode is used for the first electrode 30, as described above, it may, in a modification, be more advantageous to form the transparent electrode over the current diffusion layer 24, using a transparent conductive oxide (TCO).

In this structure, the work function of the current diffusion layer 24 may, as in this embodiment, be smaller than the work function of the p type GaN semiconductor layer as the p type semiconductor layer 23, but may, as in this embodiment be larger than the work function of the transparent electrode.

The work function ranges of the current diffusion layer 24 and p type semiconductor layer 23 may, as in this embodiment, partially overlap with each other. Also, the work function ranges of the p type semiconductor layer 23 and transparent electrode may, as in this embodiment, partially overlap with each other.

For the TCO of the transparent electrode, indium tin oxide (ITO) may be used. Other materials, such as indium zinc oxide (IZO), aluminum zinc oxide (AZO), magnesium zinc oxide (MZO), or gallium zinc oxide (GZO), may also be used.

In order to achieve an enhancement in reflection efficiency, a reflection electrode 40 is formed over the first electrode 30. It is preferred that the reflection electrode 40 be made of silver (Ag) or aluminum (Al). However other suitable materials known to the skilled person may be employed.

Meanwhile, a support layer is also be provided in this embodiment to support the semiconductor layer 20 in a process for separating the substrate 10 from the semiconductor layer 20, as will be described later. In this embodiment the support layer is made of metal or semiconductor containing Si.

Where the semiconductor layer 20 has a structure laminated in the above-described order, the first electrode 30 functions as a p type electrode.

After formation of a light emitting device chip, which includes the semiconductor layer 20, first electrode 30, and reflection electrode 40 formed as described above, the sapphire substrate 10 is completely removed from the light emitting device chip, using a laser lift off (LLO) method.

In such an LLO method, stress is applied to a GaN-based thin film upon incidence of a laser beam. In order to separate the sapphire substrate 10 from the GaN thin film, namely the semiconductor layer 20, it is necessary to use a laser beam having a high energy density. The laser beam decomposes GaN into a metal element, namely, Ga, and nitrogen gas (N₂).

In a modification, the separation of the substrate 10 may be achieved using methods other than the LLO method, for example, etching.

Thereafter, a TCO layer 50 is formed over the structure obtained after the removal of the substrate 10 in an inverted state of the structure, as shown in FIG. 5. A second electrode 60 is formed, in the form of a metal pad, on the TCO layer 50.

The TCO layer 50 functions to efficiently supply current to the semiconductor layer 20. Thus, an enhancement in light emission efficiency, an increase in light emission area, and a decrease in operating voltage can be achieved.

That is, since the total resistance of the device does not increase in spite of a reduction in contact region, effective current spreading is achieved. Accordingly, it is possible to decrease the operating voltage.

Thus, the second electrode 60 can be formed in the form of, for example, a metal pad, to have a reduced area. Accordingly, the second electrode 60 does not reduce the light emission area.

Meanwhile, as shown in the drawings, the semiconductor layer 20 may have a structure having an area gradually increasing as it extends from the first electrode 30 to the TCO layer 50. In accordance with this structure, it is possible to increase the light escape angle.

In this embodiment the TCO layer 50 is made of ZnO. Also, AlZnO or InZnO produced by adding Al or In, as a dopant, to ZnO may be used.

Although ITO may be used for the TCO layer 50, the effect of the TCO layer 50 may be small in this case because the ohmic contact between the TCO layer 50 and the n type semiconductor layer 21 of the semiconductor layer 20 may be insufficiently formed.

FIG. 6 illustrates band structures of ITO and n type GaN semiconductor before the bonding thereof. Referring to FIG. 6, ITO has a work function of about 4.7 eV and a band gap Bg of about 3.7 eV, whereas GaN has a band gap of about 3.44 eV.

When ITO and n type GaN semiconductor, which have characteristics as described above, are bonded, the Fermi level of ITO is equalized with a conduction band, namely, the Fermi level of n type GaN, as in a conductive metal, as shown in FIG. 7. In this case, a barrier ΔE_{c} blocking flow of electrons and having a level of 1.7 eV is formed.

That is, the band structure is bent at the bonding surface, so that a barrier is formed in the conduction band at the bonding surface.

When a voltage (bias) is applied to the band structure in this state, the barrier is maintained at 1.7 eV, but the band structure is further bent. Accordingly, a tunneling phenomenon occurs at the barrier, as shown in FIG. 8. As a result, current flows. In this case, when the applied voltage is higher, an increased amount of current flows because the bending degree increases.

When ZnO and n type GaN are bonded, a similar phenomenon occurs. Here, ZnO has a work function of 4.2 eV and a band gap Bg of 3.37 eV.

When ZnO and n type GaN semiconductor, which have characteristics as described above, are bonded, the Fermi level of ZnO is equalized with a conduction band, namely, the Fermi level of n type GaN, as in a conductive metal, as shown in FIG. 10. In this case, a barrier ΔE_{c} blocking flow of electrons and having a level of 1.2 eV is formed.

Since the amount of current flowing in accordance with a tunneling phenomenon is proportional to Exp[(ΔE_{c})^{3/2}], it is possible to generate a sufficient flow of current with a lower voltage, in the case in which ZnO and n type GaN are bonded.

That is, as can be seen from the above description, the case using ZnO and the case using AlZnO or InZnO added with a dopant are more advantageous in terms of flow of current.

The TCO layer 50, which is made of a ZnO-based material as described above, can greatly improve the light escape angle, through which light escapes from the inside of the GaN material.

In accordance with a simple calculation, the light escape angle, through which light can directly escape from GaN having a refractive index of 2.35 to the external of the GaN (air), is about 25°. However, when a ZnO-based material is used for the TCO layer 50, the light escape angle is greatly increased because "sin⁻¹(2.07/2.35)" is 61.74° .

Hereinafter, an embodiment of the present invention will be described with reference to FIGs. 12 to 15. In the following description, no explanation will be given of the same process as that of Figs 3-11.

As shown in FIG. 12, in order to manufacture a light emitting device according to this embodiment, a GaN-based semiconductor layer 200 and a first electrode 300 are formed over a sapphire substrate 100.

As shown in FIG. 12, the semiconductor layer 200 includes an n type semiconductor layer 210, an active layer 220, and a p type semiconductor layer 230. In order to achieve an enhancement in reflection efficiency, the first electrode 300 may include a reflection electrode 400. A support layer, which is made of metal or semiconductor containing Si, is formed over the first electrode 300.

Where the semiconductor layer 200 has a structure laminated in the above-described order, the first electrode 300 functions as a p type electrode.

After formation of a light emitting device chip as described above, the sapphire substrate 100 is completely removed from the light emitting device chip, using a laser lift off (LLO) method.

In such an LLO method, stress is applied to a GaN-based thin film upon incidence of a laser beam. In order to separate the sapphire substrate 100 from the GaN thin film, it is necessary to use a laser beam having a high energy density. The laser beam decomposes GaN into a metal element, namely, Ga, and nitrogen gas (N₂).

As shown in FIG. 13, a getter metal layer 500 is then deposited over the surface of the n type semiconductor layer 210, from which the substrate 100 has been removed, using a metal having nitrogen gettering characteristics, for example, at least one of Ti, Zr, and Cr. The getter metal layer 500 can exhibit a high reactivity to nitrogen (N) which is a Group V material in a semiconductor material of Group III to Group V such as GaN.

The deposition of the getter metal such as Ti, Zr, or Cr is achieved by coating or doping the getter metal on or in an interface of the n type semiconductor layer 210 in a small amount. For the deposition method, various methods, for example, PVD such as sputtering, MOCVD using organic metal pre-cursor, and ion implanting, may be selectively used in accordance with the convenience of the process.

After the deposition of the getter metal layer 500, a transparent conductive oxide (TCO) layer 600 having an appropriate refractive index is formed over the getter metal layer 500, in order to obtain a maximum light escape effect.

It is preferred that the TCO layer 600 be made of indium tin oxide (ITO).

After the formation of the getter metal layer 500 and TCO layer 600 over the semiconductor layer 200, a heat treatment is carried out, as shown in FIG. 14.

As is generally known, TCO such as ITO may not form an effective ohmic contact with any of n type GaN and p type GaN, as shown in FIG. 15.

However, if the TCO layer 600, which is efficient in terms of refractive index, can be applied to a top layer in a light emitting device having a vertical structure, as in the above-described structure, considerable advantages in terms of light escape may be provided.

As can be seen from the recent research results, Ga-N decomposition is observed at an ITO/GaN interface in a heat treatment. There is a report that the ohmic contact of n type GaN generally reacts with nitrogen in a Ga-N surface, thereby causing the surface to be nitrogen deficient, and thus forming ohmic contact.

Accordingly, the nitrogen getter metal layer 500 can achieve improvements in ohmic characteristics and device stability by removing nitrogen in the Ga-N structure.

As is well known, metal such as Ti can effectively prevent a degradation in electrode characteristics caused by formation of a compound because Ti easily forms a Ti-N compound, and the Ti-N exhibits conductivity as in metal.

After the formation of TCO layer 600 as described above, a second electrode 700 is formed, as an n type electrode, over the TCO layer 600. Thus, a chip structure is completely fabricated.

Accordingly, it is possible to use ITO as the TCO layer 600. As a result, it is possible to greatly improve the light escape angle, through which light escapes from the inside of the GaN material.

In accordance with a simple calculation, the light escape angle, through which light can directly escape from GaN having a refractive index of 2.35 to the external of the GaN (air), is about 25°. However, when ITO is used, the light escape angle is greatly increased to 54.78°.

It will be apparent to those skilled in the art that various modifications and variations can be made in the present invention without departing from the scope thereof as defined by the claims.

## Claims

1. A thin-film light emitting device having a vertical structure, comprising:
a support layer;
a first electrode (300) on the support layer;
a GaN-based semiconductor structure (200) having a first surface on the first electrode, the semiconductor structure comprising a p-type semiconductor layer (230) on the first electrode, an active layer (220) on the p-type semiconductor layer, and an n-type semiconductor layer (210) on the active layer;
a metal layer (500) in contact with the n-type semiconductor layer at a second surface of the semiconductor structure, wherein the second surface is opposite the first surface;
a transparent conductive oxide layer (600) in contact with the metal layer; and
a second electrode (700) on the transparent conductive oxide layer;
wherein the metal layer is arranged between the n-type semiconductor layer and the transparent conductive oxide layer, wherein the metal layer has a nitrogen gettering characteristic so as to improve ohmic characteristics of the transparent conductive oxide layer.

2. The light emitting device according to claim 1, wherein the transparent conductive oxide layer is arranged between the second electrode and the metal layer.

3. The light emitting device according to claim 1 or 2, wherein the transparent conductive oxide layer is configured to enhance current spreading characteristics.

4. The light emitting device according to claim 1 to 3, wherein the second electrode comprises a metal pad.

5. The light emitting device according to any preceding claim, wherein the first electrode comprises a reflection electrode (400).

6. The light emitting device according to any preceding claim, wherein the support layer comprises semiconductor including Si.

7. The light emitting device according to any preceding claim, wherein the first electrode comprises a transparent electrode.

8. The light emitting device according to any preceding claim, wherein the transparent conductive oxide layer has a refractive index less than the refractive index of the semiconductor structure.

9. The light emitting device according to any preceding claim, wherein the transparent conductive oxide layer comprises one or more of indium tin oxide (ITO), ZnO, AlZnO, and InZnO.

10. The light emitting device according to any preceding claim, wherein the metal layer comprises Ti, Zr, or Cr.

11. The light emitting device according to any preceding claim, wherein the semiconductor structure has an inclined side surface.

12. The light emitting device according to claim 11, wherein the inclined surface of the semiconductor structure is configured such that the area of the second surface is larger than the area of the first surface.

13. The light emitting device according to any preceding claim, wherein the support layer comprises metal or semiconductor.

14. The light emitting device according to any preceding claim, wherein the support layer contacts the first electrode.

15. The light emitting device according to any preceding claim, wherein an area of a surface of the first electrode facing the semiconductor structure is smaller than an area of second surface of the semiconductor structure.

16. The light emitting device according to claim 11, wherein the inclined side surface is configured to enhance the light extraction capability of the device.

17. The light emitting device according to any preceding claim, wherein the metal layer has a third surface facing the second electrode and the second electrode has a fourth surface facing the metal layer, and wherein the area of the third surface is different from the area of the fourth surface.

18. The light emitting device according to any preceding claim, wherein the transparent conductive oxide layer contacts the second electrode.

19. The light emitting device according to any preceding claim, wherein the transparent conductive oxide layer covers the entire second surface of the semiconductor structure.

20. The light emitting device according to any preceding claim, wherein the metal layer contacts the entire second surface of the semiconductor structure.

21. The light emitting device according to any preceding claim, wherein the transparent conductive oxide layer is arranged to facilitate light generated from the active layer to escape from the semiconductor structure.

## Patentansprüche

1. Dünnfilm-Lichtemittierungsvorrichtung, die eine vertikale Struktur aufweist, umfassend:
eine Trägerschicht;
eine erste Elektrode (300) auf der Trägerschicht;
eine GaN-basierte Halbleiterstruktur (200), die eine erste Oberfläche auf der ersten Elektrode aufweist, wobei die Halbleiterstruktur eine p-Typ-Halbleiterschicht (230) auf der ersten Elektrode, eine aktive Schicht (220) auf der p-Typ-Halbleiterschicht, und eine n-Typ-Halbleiterschicht (210) auf der aktiven Schicht umfasst;
eine Metallschicht (500) in Kontakt mit der n-Typ-Halbleiterschicht an einer zweiten Oberfläche der Halbleiterstruktur, wobei die zweite Oberfläche gegenüber der ersten Oberfläche liegt;
eine transparente leitende Oxidschicht (600) in Kontakt mit der Metallschicht; und
eine zweite Elektrode (700) auf der transparenten leitenden Oxidschicht (600);
wobei die Metallschicht zwischen der n-Typ-Halbleiterschicht und der transparenten leitenden Oxidschicht angeordnet ist, wobei die Metallschicht eine Stickstoffgetterungseigenschaft aufweist, um ohmsche Eigenschaften der transparenten leitenden Oxidschicht zu verbessern.

2. Lichtemittierungsvorrichtung nach Anspruch 1, wobei die transparente leitende Oxidschicht zwischen der zweiten Elektrode und der Metallschicht angeordnet ist.

3. Lichtemittierungsvorrichtung nach Anspruch 1 oder 2, wobei die transparente leitende Oxidschicht dazu konfiguriert ist, Stromverbreitungseigenschaften zu steigern.

4. Lichtemittierungsvorrichtung nach Anspruch 1 bis 3, wobei die zweite Elektrode ein Metall-Pad umfasst.

5. Lichtemittierungsvorrichtung nach einem vorhergehenden Anspruch, wobei die erste Elektrode eine Reflexionselektrode (400) umfasst.

6. Lichtemittierungsvorrichtung nach einem vorhergehenden Anspruch, wobei die Trägerschicht einen Si umfassenden Halbleiter umfasst.

7. Lichtemittierungsvorrichtung nach einem vorhergehenden Anspruch, wobei die erste Elektrode eine transparente Elektrode umfasst.

8. Lichtemittierungsvorrichtung nach einem vorhergehenden Anspruch, wobei die transparente leitende Oxidschicht einen Brechungsindex aufweist, der geringer als der Brechungsindex der Halbleiterstruktur ist.

9. Lichtemittierungsvorrichtung nach einem vorhergehenden Anspruch, wobei die transparente leitende Oxidschicht Indiumzinnoxid (ITO), ZnO, AlZnO und/oder InZnO umfasst.

10. Lichtemittierungsvorrichtung nach einem vorhergehenden Anspruch, wobei die Metallschicht Ti, Zr oder Cr umfasst.

11. Lichtemittierungsvorrichtung nach einem vorhergehenden Anspruch, wobei die Halbleiterstruktur eine geneigte Seitenfläche aufweist.

12. Lichtemittierungsvorrichtung nach Anspruch 11, wobei die geneigte Oberfläche der Halbleiterstruktur derart konfiguriert ist, dass der Bereich der zweiten Oberfläche größer als der Bereich der ersten Oberfläche ist.

13. Lichtemittierungsvorrichtung nach einem vorhergehenden Anspruch, wobei die Trägerschicht Metall oder einen Halbleiter umfasst.

14. Lichtemittierungsvorrichtung nach einem vorhergehenden Anspruch, wobei die Trägerschicht die erste Elektrode kontaktiert.

15. Lichtemittierungsvorrichtung nach einem vorhergehenden Anspruch, wobei ein Bereich einer der Halbleiterstruktur zugewandten Oberfläche der ersten Elektrode kleiner als ein Bereich der zweiten Oberfläche der Halbleiterstruktur ist.

16. Lichtemittierungsvorrichtung nach Anspruch 11, wobei die geneigte Seitenfläche dazu konfiguriert ist, die Lichtextraktionsfähigkeit der Vorrichtung zu steigern.

17. Lichtemittierungsvorrichtung nach einem vorhergehenden Anspruch, wobei die Metallschicht eine dritte Oberfläche aufweist, die der zweiten Elektrode zugewandt ist, und die zweite Elektrode eine vierte Oberfläche aufweist, die der Metallschicht zugewandt ist, und wobei der Bereich der dritten Oberfläche unterschiedlich von dem Bereich der vierten Oberfläche ist.

18. Lichtemittierungsvorrichtung nach einem vorhergehenden Anspruch, wobei die transparente leitende Oxidschicht die zweite Elektrode kontaktiert.

19. Lichtemittierungsvorrichtung nach einem vorhergehenden Anspruch, wobei die transparente leitende Oxidschicht die gesamte zweite Oberfläche der Halbleiterstruktur bedeckt.

20. Lichtemittierungsvorrichtung nach einem vorhergehenden Anspruch, wobei die Metallschicht die gesamte zweite Oberfläche der Halbleiterstruktur kontaktiert.

21. Lichtemittierungsvorrichtung nach einem vorhergehenden Anspruch, wobei die transparente leitende Oxidschicht so angeordnet ist, dass sie es dem von der aktiven Schicht erzeugten Licht erleichtert, aus der Halbleiterstruktur zu entkommen.

## Revendications

1. Un dispositif d'émission de lumière à film mince ayant une structure verticale, comprenant :
une couche de support ;
une première électrode (300) sur la couche de support ;
une structure semi-conductrice (200) à base de GaN, ayant une première surface sur la première électrode, la structure semi-conductrice comprenant une couche semi-conductrice (230) de type p sur la première électrode, une couche active (220) sur la couche semi-conductrice de type p, et une couche semi-conductrice (210) de type n sur la couche active ;
une couche de métal (500) en contact avec la couche semi-conductrice de type n sur une deuxième surface de la structure semi-conductrice, la deuxième surface étant opposée à la première surface ;
une couche d'oxyde conductrice transparente (600) en contact avec la couche de métal ; et
une deuxième électrode (700) sur la couche d'oxyde conductrice transparente ;
la couche de métal étant disposée entre la couche de semi-conducteur de type n et la couche d'oxyde conductrice transparente, la couche de métal ayant une caractéristique de piégeage d'azote de manière à améliorer les caractéristiques ohmiques de la couche d'oxyde conductrice transparente.

2. Le dispositif d'émission de lumière selon la revendication 1, dans lequel la couche d'oxyde conductrice transparente est agencée entre la deuxième électrode et la couche métallique.

3. Le dispositif d'émission de lumière selon la revendication 1 ou la revendication 2, dans lequel la couche d'oxyde conductrice transparente est configurée pour améliorer les caractéristiques d'étalement du courant.

4. Le dispositif d'émission de lumière selon les revendications 1 à 3, dans lequel la deuxième électrode comprend un coussinet métallique.

5. Le dispositif d'émission de lumière selon l'une quelconque des revendications précédentes, dans lequel la première électrode comprend une électrode de réflexion (400).

6. Le dispositif d'émission de lumière selon l'une quelconque des revendications précédentes, dans lequel la couche de support comprend un semi-conducteur incluant du Si.

7. Le dispositif d'émission de lumière selon l'une quelconque des revendications précédentes, dans lequel la première électrode comprend une électrode transparente.

8. Le dispositif d'émission de lumière selon l'une quelconque des revendications précédentes, dans lequel la couche d'oxyde conductrice transparente a un indice de réfraction inférieur à l'indice de réfraction de la structure semi-conductrice.

9. Le dispositif d'émission de lumière selon l'une quelconque des revendications précédentes, dans lequel la couche d'oxyde conductrice transparente comprend un ou plusieurs des oxydes d'indium et d'étain (ITO), ZnO, AlZnO et InZnO.

10. Le dispositif d'émission de lumière selon l'une quelconque des revendications précédentes, dans lequel la couche métallique comprend du Ti, du Zr ou du Cr.

11. Le dispositif d'émission de lumière selon l'une quelconque des revendications précédentes, dans lequel la structure semi-conductrice a une surface latérale inclinée.

12. Le dispositif d'émission de lumière selon la revendication 11, dans lequel la surface inclinée de la structure semi-conductrice est configurée de telle sorte que la superficie de la deuxième surface est supérieure à la superficie de la première surface.

13. Le dispositif d'émission de lumière selon l'une quelconque des revendications précédentes, dans lequel la couche de support comprend un métal ou un semi-conducteur.

14. Le dispositif d'émission de lumière selon l'une quelconque des revendications précédentes, dans lequel la couche de support est en contact avec la première électrode.

15. Le dispositif d'émission de lumière selon l'une quelconque des revendications précédentes, dans lequel une zone d'une surface de la première électrode tournée vers à la structure semi-conductrice est plus petite qu'une zone de deuxième surface de la structure semi-conductrice.

16. Le dispositif émetteur de lumière selon la revendication 11, dans lequel la surface latérale inclinée est configurée pour améliorer la capacité d'extraction de lumière du dispositif.

17. Le dispositif émetteur de lumière selon l'une quelconque des revendications précédentes, dans lequel la couche métallique a une troisième surface tournée vers la deuxième électrode et la deuxième électrode a une quatrième surface tournée vers la couche métallique, et dans lequel la superficie de la troisième surface est différente de la superficie de la quatrième surface.

18. Le dispositif d'émission de lumière selon l'une quelconque des revendications précédentes, dans lequel la couche d'oxyde conductrice transparente est en contact avec la deuxième électrode.

19. Le dispositif d'émission de lumière selon l'une quelconque des revendications précédentes, dans lequel la couche d'oxyde conductrice transparente recouvre la totalité de la deuxième surface de la structure semi-conductrice.

20. Le dispositif d'émission de lumière selon l'une quelconque des revendications précédentes, dans lequel la couche métallique est en contact avec l'intégralité de la deuxième surface de la structure semi-conductrice.

21. Le dispositif d'émission de lumière selon l'une quelconque des revendications précédentes, dans lequel la couche d'oxyde conductrice transparente est agencée pour faciliter l'échappement, depuis la structure semi-conductrice, de la lumière générée à partir de la couche active.
